# EUROPEAN PATENT SPECIFICATION

(11) **EP 3 534 163 B1**
(45) Date of publication and mention of the grant of the patent: **19.06.2024**
(21) Application number: 19159639.4
(22) Date of filing: 27.02.2019
(51) Int. Cl.: G01R 19/00, G01R 29/08, G01R 1/067, H04B 1/00

(54) **PROBE WITH BROADBAND ANTENNA**
SONDE MIT BREITBANDANTENNE
SONDE COMPORTANT UNE ANTENNE À LARGE BANDE

(30) Priority: 28.02.2018 NL 2020509
(43) Date of publication of application: 04.09.2019
(73) Proprietor: Inpacare B.V., 3447 GX Woerden (NL)
(72) Inventor: DIJKSTRA, Patrick Walter Joseph, 3465 TJ Driebruggen (NL); VAN PEER, Antonius Josephus, 6700 Bludenz (AT)
(74) Representative: D'Halleweyn, Nele Veerle Trees Gertrudis

(56) References cited:
- WO-A1-2009/020388
- DE-A1-102010 027 567
- US-A- 3 750 017
- US-A- 5 512 823
- US-A1- 2008 001 611

## Description

The present invention relates to a probe or sensor for measuring an electrical field, comprising at least one antenna, a detection circuit for each antenna, which detection circuit is connected to the corresponding antenna for detecting an RF signal, and a processing unit for processing the detected signal.

Such probes are also known as field probes which are typically used to measure RF fields for all manner of applications, such as measuring the electrical field strength during testing or radiation immunity, calibration of the electrical field in test arrangements, determining the homogeneity of the electrical field in a test installation or measuring the electrical field strength in order to determine whether the field levels lie below a value acceptable for persons.

The known field probes typically use a number of antenna elements and circuit for converting the RF signal into a DC current with an amplitude which is a function of the amplitude of the RF signal. It is desirable that such probes operate properly, and in particular are isotropic in a wide frequency and amplitude range.

Such a probe is for instance described in WO 2009/020388. The probe described therein has three antenna subsystems which are oriented along respectively an X, Y and Z axis. The antenna elements are connected to a detection/filter circuit, from where the detected signals are transmitted to a processing circuit connected to a power supply and communication circuit, from where optical data signals are sent via an optical fiber for further processing, for instance on a PC. This probe comprises three monopole antennas. Each antenna is connected to a housing with a substantially spherical surface for forming a ground plane. The antennas and at least a part of the detection system is arranged outside the housing while the processing circuit is arranged inside the housing. The advantage of such set-up is that interference between the housing, the antenna, the RF signal and the processing elements can be minimized. This significantly improves the reliability of the measurement. A single frequency band is used.

US 5,512,823 discloses a hand-held detector for determining whether the exposure to electromagnetic fields resulting from electric power lines, faulty wiring, and electrical and electronic appliances is within acceptable limits.

US 2008/0001611 A1 discloses a method and apparatus for probing an electrical signal. The apparatus comprises simplified circuit, comprising an input pin for receiving an input signal having an inductance and parasitic capacitance associated therewith and a first resistor coupled between the input pin and an output.

DE 10 2010 027 567 A1 discloses a sensor-head system with various amplifiers for high and low frequency components.

It is an object of the present invention to provide a probe for measuring an electric field, which allows an accurate measurement over a wide frequency range.

To this end, the invention proposes a probe for measuring an electrical field, comprising:
- at least one antenna adapted to receive a broadband RF signal;
- a diplexer comprising an input coupled to the antenna, the diplexer being configured for transmitting the received broadband RF signal to a low frequency band signal output and a high frequency band signal output such that the broadband RF signal is reflected in the combination of the low frequency band signal output and the high frequency band signal output;
- a low frequency band detection circuit connected to the low frequency band signal output for detecting a low frequency band RF signal, and adapted for feeding the detected signal to a processing circuit;
- a high frequency band detection circuit connected to the high frequency band signal output for detecting a high frequency band RF signal and adapted for feeding the detected signal to said processing circuit; and
- said processing circuit for processing the detected signals.

In the probe of the invention the output of the antenna is split into at least two signals. A diplexer is provided for this purpose. A diplexer is defined as a circuit adapted to split an input signal into at least two output signals. A low frequency signal is detected by a low frequency band detection circuit, while a high frequency signal is detected by a high frequency band detection circuit. Both detected signals are fed to a processing circuit for processing the detected signals. In prior art probe systems, a single antenna is coupled to a single detection circuit. When it is desired in the prior art to separately detect a low frequency and a high frequency by separate detection circuits, separate corresponding antennas are provided. Typically, a monopole antenna is used for high frequencies, while a disc antenna is typically provided at the base of the monopole antenna and adapted for measuring low frequencies. Such set-ups with separate antennas for low and high frequencies require a housing to be more complex, so that interferences between the housing, the antenna and the RF signal increase. Furthermore in such set-up the probe will be less symmetrical, reducing isotropic behavior. Since the probe of the invention uses a single antenna, this drawback is eliminated. The invention is further based on the insight that a detection circuit has a limited accurate range of operation. When the detection circuit would be optimized for accurately measuring low frequencies, then accurately measuring high frequencies is difficult. Furthermore, when the detection circuit is optimized for accurately measuring high frequencies, measuring low frequencies is difficult. Since two detection circuits are provided in the probe of the invention, each circuit can be optimized for measuring signals within its frequency range, thereby increasing the overall accuracy of the probe. The diplexer is further provided such that the RF signal from the antenna, which is a broadband RF signal, is reflected in the combination of the low frequency band signal output and the high frequency band signal output. The direct result of this technical feature is that the detection of the low frequency band signal by the low frequency band detection circuit and the high frequency band signal by the high frequency band detection circuit allows to at least partly calculate the broadband RF signal. The direct result is that the broadband RF signal is accurately retrievable from a combination of the high frequency signal detected by the high frequency band detection circuit and the low frequency signal detected by the low frequency band detection circuit. As described above, each of these detection circuits can be optimized for operation within their frequency range, so that the overall accuracy is improved.

Preferably, the probe comprises a housing in which the processing unit is arranged. The housing is preferably conductive and has at least partly a substantially spherical surface for the purpose of forming a ground plane for the at least one antenna. In this manner, the housing forms a Faraday cage and the processing circuit is fully shielded from external RF signals, whereby the DC measuring circuits will not be influenced. This is because only the DC signals coming from the detection circuits are carried into the housing. In this way, very weak high frequency signals can also be measured accurately, this being a prerequisite for being able to operate with short antenna elements. These short antenna elements are desirable, on the one hand, because the total measuring volume of the probe is hereby reduced, and on the other hand, because the maximum operating frequency can thereby be increased.

Preferably, the high frequency band detection circuit is arranged outside of the housing. When the high frequency band detection circuit is arranged outside the housing, and the processing circuit is arranged inside the housing, the RF signals processed by the high frequency band detection system will not influence the circuits of the processing circuit, so that the measurement will be more accurate.

Preferably, the high frequency band detection circuit is coupled to the processing circuit via a feedthrough capacitor with a feedthrough tunnel and a shield, wherein the feedthrough tunnel connects the detection circuit conductively to the processing circuit and the shield is connected conductively to the conductive surface of the housing. This set-up is further optimized for shielding the measuring circuits and processing circuit from the high frequency signals processed by the high frequency band detection circuit. A further effect is that the housing is conductive and the plate is arranged perpendicularly on the conductive housing, this such that the conductive strip makes contact with the housing.

Preferably, the low frequency band detection circuit is arranged inside of the housing. By providing the low frequency band detection circuit inside the housing, the low frequency band detection circuit will not be influenced by RF signals present outside of the housing. Furthermore, the low frequency band detection circuit is typically less disturbing for elements of the processing circuit, such that providing the low frequency band detection circuit inside the housing does not affect correct operation of the processing circuit.

Preferably, the low frequency band detection circuit is connected to the low frequency band signal output via an amplifier, preferably a FET amplifier, more preferably a JFET amplifier. By connecting an amplifier to the low frequency band signal output, the impedance of the input to the amplifier can be chosen high. This is needed while low frequency fields are high impedant and should not be loaded by the detector input impedance. This further improves the accuracy of the probe. Furthermore, the amplified signal can be directly processed by the low frequency band detection circuit, thereby keeping the distance between the low frequency band detection circuit and the amplifier as small as possible to minimize affecting the processing circuit. Therefore, the amplifier is preferably arranged inside the housing.

Preferably, the diplexer is configured to provide an impedance at the low frequency band signal output which is significantly higher than an impedance at the high frequency band signal output. The skilled person will realize that the impedance is frequency dependent. Therefore, the skilled person will understand that providing an impedance at the low frequency band signal output relates to the impedance when a low frequency is fed, while the impedance at the high frequency band signal output relates to an impedance when a high frequency is fed to the output. Since a higher impedance is provided to the low frequency band signal output compared to the high frequency band signal output, currents that flow out of the diplexer in relation to the low frequency band signals are significantly lower. As explained above, these signals are processed inside the probe, such that having relatively low currents at the low frequency output has as an advantage that little or no RF disturbance will occur inside the probe. The lower impedance at the high frequency band signal output will typically result in higher currents which are processed by the high frequency band detection circuit. As explained above, this circuit is preferably provided outside of the housing, such that these high currents cannot influence the measuring circuits at the inside of the housing. Tests have shown that high currents are more optimal to accurately measure a high frequency signal. Tests have further shown that a higher impedance at the low frequency band signal output has as a result that the high frequency band is not influenced or at least minimally affected by the low frequency part.

Preferably, the diplexer comprises a chain of resistant components bridging a distance between the input of the diplexer and the low frequency band signal output of the diplexer by forming a resistive connection path, thereby reducing or minimizing the need for conductor elements such as copper in the connection path. The resistor elements are for example SMD components in a 0201-housing. These are small housings which are known to be small with respect to the wavelengths of the received high frequency signal. Therefore they do not substantially react or interact with these signals. Such components are typically small such that multiple components are used in succession to bridge the distance. The direct result is that use of a copper path, typically used to connect elements in an electronic circuit, can be minimized while realizing the connection. Such copper path would be suboptimal since it would react to the RF signals thereby disturbing the measurement. A further advantage related to the use of multiple resistant components is that a divided resistance avoids that resonance occurs.

Preferably, the diplexer comprises a capacitor component arranged between the high frequency band signal output and the input of the diplexer. For high frequencies, a capacitor component has a low resistance which is an advantage as explained above.

Preferably, the at least one antenna is a monopole antenna with a resistivity of at least 100 Ohm, preferably at least 200 Ohm, most preferably about 120π Ohm. The resistivity has as a result that resonance is less likely to occur since the resistive character of the antenna will reduce the resonance.

Preferably, at least three antennas are arranged on the housing in accordance with three axes oriented perpendicularly of each other. Each of these antennas can measure an RF signal in one of the three orientations. Therefore the three antennas provide the probe with an isotropic output.

Preferably, the at least three antennas comprise six antennas provided in pairs arranged on opposite sides of the housing such that the pairs are arranged on the housing in accordance with three axes oriented perpendicularly of each other. Six antennas further improve the isotropic nature of the probe.

Preferably, each detection circuit comprises at least a peak detector, which is connected to the processing unit via a ranging amplifier and an A/D convertor.

The invention will now be described in more details with respect to the drawings illustrating some preferred embodiments of the invention. In the drawings:
figure 1A illustrates a first embodiment of a probe of the invention;
figure 1B illustrates a second embodiment of a probe of the invention;
figure 2A and 2B illustrate a housing of a probe of the invention;
figure 3 illustrates a block scheme with elements for connecting an antenna to a processing circuit according to an embodiment of the invention;
figure 4 illustrates a detection circuit according to an embodiment of the invention; and
figure 5 illustrates an amplitude response of the probe over the frequency range when an RF signal is emitted over the frequency range with a constant amplitude at the emitting side.

In the drawings a same reference number has been allocated to a same or analogous element.

The probe of the invention is primarily developed for use in electromagnetic compatibility (EMC) immunity testing. The skilled person will realize that the probe could also be used for other purposes. At present, during electromagnetic compatibility (EMC) immunity testing, at the emitting side, a signal generator, a high power RF amplifier, and a broadband antenna are used to generate a broadband RF field, typically in an EMC room such as an anechoic chamber or a Faraday cage. These systems most commonly are used in the frequency ranges of 9 kHz to 30 MHz, 30 MHz to 1 GHz, 1 GHz to 6 GHz, 1 GHz to 18 GHz and 1 GHz to 40 GHz. More generally, any range between 9 kHz and 40 GHz can be used. In such a system typically the high power RF amplifier is located outside the EMC room and the broadband antenna is located inside the room. Typically, the RF power is generated through combining a number of low power amplifiers, wherein significant power losses may occur as a result of the combiners. Also, further power losses occur in the cable connection between the power amplifier outside the EMC room and the broadband antenna inside the room.

In the context of the present application broadband refers to an operable range covering at least the range relevant in EMC testing. In other words, according to the invention e.g. the operable range of the antenna is preferably about 9kHz - 6GHz. The lower border of the operable range of the broadband antenna is preferably lower than 25kHz, more preferably lower than 15kHz, most preferably lower than 10kHz. The upper border of the operable range of the broadband antenna is preferably higher than 2GHz, more preferably higher than 4GHz, most preferably higher than 10GHz.

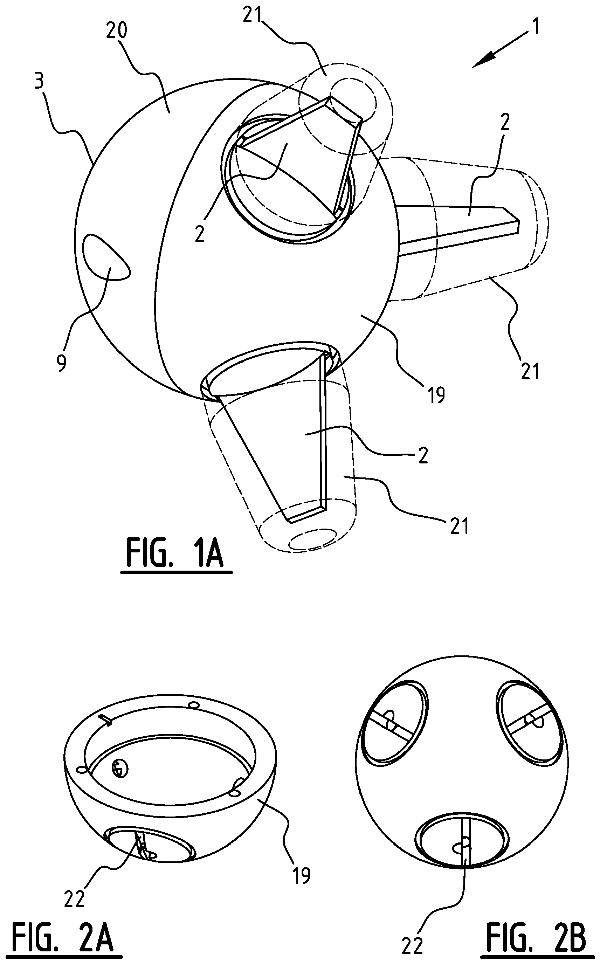

In the embodiment illustrated in figure 1A the housing 3 is constructed of two substantially spherical parts 19, 20 which are manufactured from a conductive material, typically a metal, and preferably optionally gilded brass. Three monopole antennas 2 are arranged on a first part 19 of the housing in an X, Y and Z direction of an orthogonal coordinate system. Each antenna is enclosed by a protective cap 21 typically manufactured from a material with a low dielectric constant and a low tanδ, such as HMP (high-molecular polyethylene).

Note that it is particularly important that the outer surface around antennas 2 is substantially spherical and that the other part of the housing can also take a different form, wherein the dimensions of the antenna must preferably be small relative to those of the ground plane formed by the outer surface of the housing around each antenna.

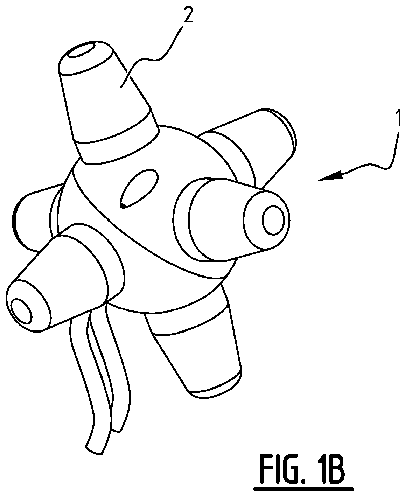

Figure 1B shows an antenna with a further improved isotropy. The probe of figure 1B comprises 6 antennas arranged in pairs on the X, Y and Z directions of the orthogonal coordinate system.

Figures 2A and B show that first part 19 is provided with three antenna mounts 22 in which a substrate with monopole 2 can be arranged in each case. In the centre of each mount 22 a continuous hole is provided for a feedthrough capacitor, as will be further explained. A circular channel is further provided around each antenna for mounting of protective cap 21.

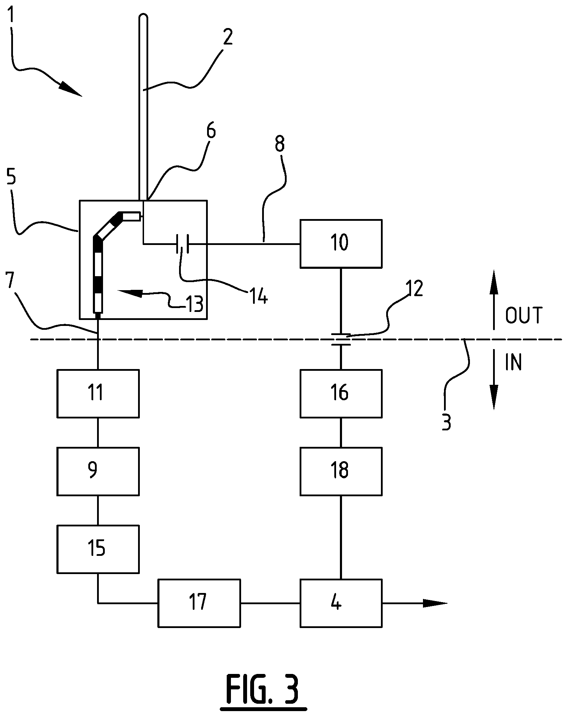

Figure 3 schematically illustrates how a probe 1 can be constructed according to an embodiment of the invention. Figure 3 shows only one antenna 2 connected to a processing unit 4. It will be clear for the skilled person that multiple antennas 2 can be provided on the housing, wherein each of these antennas 2 is connected to the processing unit 4 using the same structure and/or principles as explained hereunder and as shown in figure 3. The skilled person will also recognize that some components in the housing 3 may be used sequentially by multiple antennas.

Antenna 2 is positioned on an outside of the housing 3. Since figure 3 is a schematic illustration, the housing 3 is illustrated by a dotted line, wherein the upper part of the dotted line shows the components that are outside of the housing, while the components shown below the dotted line, are held to be inside the housing 3. The antenna 2 is preferably positioned perpendicular to an outer surface of the housing. When the housing is spherical or at least partly spherical, the antenna 2 is preferably perpendicular to a tangent plane at the connection point with the housing.

The antenna 2 is connected to a diplexer 5. In particular, an output of the antenna 2 is directly connected to an input of the diplexer 5. To minimize interference, connection paths or connection wires from a conductive material such as copper are to be avoided. The diplexer 5 has two outputs being a low frequency output 7 and a high frequency output 8. These low and high frequencies are chosen such that the upper border of the low frequency output corresponds to the lower border of the high frequency output such that the broadband frequency output of the antenna is reflected in the combination of the low frequency output and the high frequency output. In particular, the broadband frequency output of the antenna is calculated by combining the low frequency output and the high frequency output. The combination can be numeric or using a mathematical formula. According to one example, the combination is made by taking the root of the sum of the squares. The mathematical formula in this case is: Etot = √(Elow² + Ehigh²)

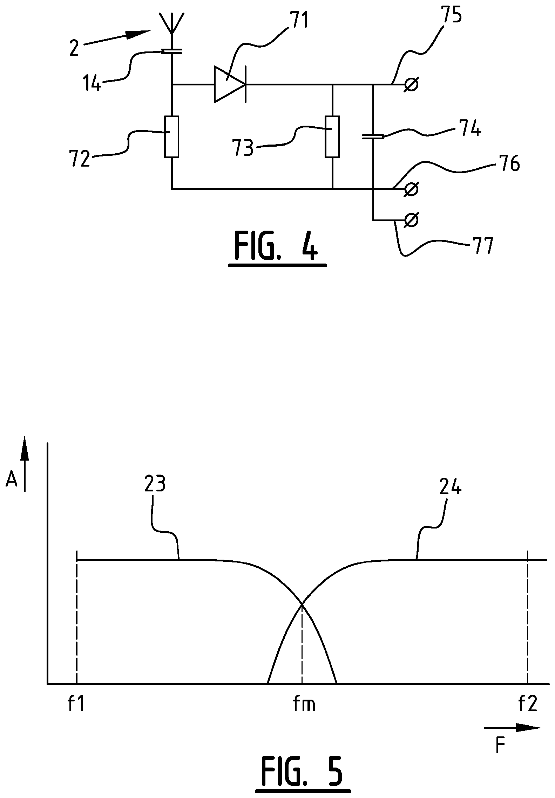

Inside the diplexer, conductive paths are minimized. To this end, the input 6 of the diplexer 5 is directly connected to a chain of resistor components 13 bridging a distance between the input 6 and the low frequency output 7. The chain of resistor components preferably comprises resistor components having different resistive properties so as to avoid resonances within the chain of resistor components. The total resistance is determined to obtain predetermined characteristics which are further explained in relation to figure 5. The components in the chain of resistor components 13 are preferably chosen from SMD components in a 0201-housing. These housings are very small housings such that these components are not likely to react to RF signals. Multiple of these resistant components are used to bridge the distance between the input of the diplexer and the low frequency output of the diplexer.

In figure 3 the input of the diplexer 5 is connected to the high frequency output 8 of the diplexer 5 via a capacitor 14. For clarity purposes, in figure 3 conductive paths are shown to connect the input 6 of the diplexer 5 to the capacitor 14; in practice the capacitor component 14 is preferably directly connected to the output of the antenna 2 to avoid interference with the RF signals. Also the output of the capacitor component 14 is preferably directly connected to the high frequency detection circuit 10. An example of a high frequency detection circuit 10 is shown in figure 4 and explained hereunder.

From the diplexer 5, a high frequency signal manipulation path is provided towards the procession unit and a low frequency signal manipulation path is provided to the processing unit 4. In figure 3, the high frequency signal manipulation path comprises the high frequency detection circuit 10, the feedthrough capacitor 12, the high frequency ranging amplifier 16, and the high frequency analogue/digital (hereafter A/D) convertor 18. The low frequency signal manipulation path of figure 3 comprises the amplifier 11, the low frequency detection circuit 9, the low frequency ranging amplifier 15 and the low frequency A/D convertor. The processing unit 4 receives both the detected high frequency signal and low frequency signal, and processes these signals to accurately measure the amplitude of the RF signal received by the antenna 2.

The high frequency detection circuit 10 is preferably provided on an outside of the housing 3 so that the high frequency signals processed by this detection circuit do not affect or influence the electronic components and/or circuits on the inside of the housing. The high frequency signal manipulation path further comprises a feedthrough capacitor feeding an output of the high frequency detection circuit into the housing to the high frequency ranging amplifier. The high frequency ranging amplifier 16 can be formed in different ways, for example by a single amplifier or by a number of different amplifiers which are useable as the situation requires. Multiple amplifiers can be used alternating or sequentially. The low frequency ranging amplifier 15 and high frequency ranging amplifier 16 could be formed in one module and/or a single ranging amplifier can be used successively or sequentially for multiple antennas. The output of the high frequency ranging amplifier 16 is connected to a high frequency A/D convertor 18 which provides the digital output to the processing unit 4 for further processing. Also a single A/D convertor could be used to sequentially convert signals from multiple antennas and/or from multiple amplifiers 15, 16.

In the low frequency signal manipulation path, a similar set-up of components is provided. In the low frequency signal manipulation path, the output of the diplexer 5 is first connected to an amplifier, preferably a FET amplifier and more preferably a JFET amplifier. The amplifier is preferably selected to have a high input impedance and a low input capacity. A high input capacity would limit the operating range of the low band so that a dip is created between the high band and the low band. Together with the chain of resistor components 13, this gives the low frequency output of the diplexer 5 a high impedance and little or no currents will flow through the low frequency output of the diplexer. The direct result is that little or no RF interference occurs inside the probe housing 3. An output of the amplifier 11 is preferably directly provided to a low frequency detection circuit 9. The low frequency detection circuit is preferably formed in a similar manner than the high frequency detection circuit. By directly coupling an output of the amplifier to the low frequency detection circuit, again interference is minimized. The output of the low frequency detection circuit is transmitted to a low frequency ranging amplifier 15, which provides an output to a low frequency A/D convertor 17. The output of the low frequency A/D convertor is provided to the processor 4 for further processing. The skilled person will recognize that the different elements in the system can be balanced to obtain an accurate output.

In an alternative embodiment, the diplexer 5 of figure 3 is formed as a splitter to split an input 6 into two outputs 7 and 8 which may be substantially identical. In such embodiment, each of the detection circuits 9 and 10 is adapted to measure signals within their predetermined frequency range such that the combination of the splitter and detection circuits function and/or perform as a diplexer having a low and high frequency output. The further processing of signals can be done as explained above.

Figure 4 shows an embodiment of a detection circuit. Hereunder, an example is given of how such detection circuit can be balanced to provide a reliable output. The example is given for a high frequency detection circuit 10. The skilled person will appreciate that the detection circuit can also be designed and laid out differently. The detection circuit comprises a detection diode 71. The capacitor 14 is connected between the antenna 2 and the anode of the detection diode 71. A first resistor 72 of for instance 100 kS2 is arranged, and a second resistor 73 of for instance 1 MΩ. The detection/filter circuit further comprises a capacitor 74 of for instance 10 pF. The capacitor is preferably a single-layer capacitor. SMD (Surface Mount Device) components (for instance of the 0402 type) with good HF properties, i.e. a capacitor with a low induction, are preferably applied for these components 72-74. The detector must preferably be suitable for frequencies to a minimum of 6 GHz, and more preferably for higher frequencies up to 40 GHz. The detection circuit has output terminal 75, 76, 77 for connection to circuitry inside the housing of the probe.

Owing to such a mounting of the monopole elements on the housing the parasitic pick-up of fields behind the detector circuit before the DC signal is fed into the Faraday cage is limited to a minimum, this enhancing the accuracy of the probe. Very weak signals can thus also be detected. Furthermore, the symmetrical construction results in a probe with good isotropic properties.

Electronics can be accommodated in the housing as described in WO2009/020388. However the skilled person will realize that other accommodations can be made. For example while the incorporated accommodation uses a single set of ranging amplifiers to sequentially amplify the signals from the different antennas, figure 3 shows an alternative embodiment wherein each antenna is coupled to its dedicated ranging amplifier.

Antenna 2 used in the present invention can be manufactured as described in WO2009/020388. The skilled person will understand that other antennas can be used that can be operated within the abovementioned broadband range.

Figure 5 shows a graph wherein the amplitude of a low frequency detected signal is shown by line 23 and the amplitude of a high frequency detected signal is shown by line 24. The diplexer 5 is designed such that the chain of resistor components 13 passes the frequencies below a splitting frequency FM. The capacitor 14 is selected to allow frequencies to pass above the frequency FM. The skilled person will realize that around frequency FM the signal received by the antenna is reflected in a combination of the low frequency signal and high frequency signal. The antenna is a broadband antenna which is able to receive RF signals between f1 and f2. As explained above, f1 can be 9 kHz and f2 can be 6 GHz. FM typically lays between 1 MHz and 100 MHz, preferably around 10 MHz.

The skilled person will appreciate that the invention is not limited to the above described exemplary embodiments and that many modifications and variants are possible without departing from the scope of the invention, wherein the scope of protection is defined solely by the appended claims.

### List of references

- 1.: probe
- 2.: antenna
- 3.: housing
- 4.: processing unit
- 5.: diplexer
- 6.: input
- 7.: LF output
- 8.: HF output
- 9.: LF detection unit
- 10.: HF detection unit
- 11.: amplifier
- 12.: feedthrough capacitor
- 13.: chain of resistor components
- 14.: capacitor
- 15.: ranging amplifier LF
- 16.: ranging amplifier HF
- 17.: A/D LF
- 18.: A/D HF
- 19.: Spherical
- 71.: Detection diode
- 72.: first resistor
- 73.: second resistor
- 74.: capacitor
- 75.: terminal
- 76.: terminal
- 77.: terminal

## Claims

1. Probe (1) for measuring an electrical field, comprising:
- at least one antenna (2) adapted to receive a broadband RF signal;
- a diplexer (5) comprising an input (6) coupled to the antenna, the diplexer being configured for transmitting the received broadband RF signal to a low frequency band signal output (7) and a high frequency band signal output (8) such that the broadband RF signal is reflected in the combination of the low frequency band signal output (7) and the high frequency band signal output (8);
- a low frequency band detection circuit (9) connected to the low frequency band signal output (7) for detecting a low frequency band RF signal, and adapted for feeding the detected signal to a processing circuit (4);
- a high frequency band detection circuit (10) connected to the high frequency band signal output (8) for detecting a high frequency band RF signal and adapted for feeding the detected signal to said processing circuit (4); and
- said processing circuit (4) for processing the detected signals.

2. The probe according to claim 1, wherein the probe comprises a housing (3) in which the processing circuit (4) is arranged.

3. The probe according to claim 1 or 2, wherein the high frequency band detection circuit (10) is arranged outside of said housing.

4. The probe according to claim 3, wherein the high frequency band detection circuit (10) is coupled to the processing circuit via a feedthrough capacitor (12) with a feedthrough terminal and a shield, wherein the feedthrough terminal connects the detection circuit conductively to the processing circuit and the shield is connected conductively to the conductive surface of the housing.

5. The probe according to any one of the previous claims, wherein the low frequency band detection circuit (9) is arranged inside of said housing.

6. The probe according to any one of the previous claims, wherein the low frequency band detection circuit (9) is connected to the low frequency band signal output (7) via an amplifier (11), preferably a FET amplifier, more preferably a JFET amplifier; wherein preferably the amplifier is arranged inside of said housing.

7. The probe according to any one of the previous claims, wherein the diplexer is configured to provide an impedance at the low frequency band signal output (7) which is significantly higher than an impedance at the high frequency band signal output (8).

8. The probe according to any one of the previous claims, wherein the diplexer comprises a chain of resistor components (13) bridging a distance between the input (6) of the diplexer and the low frequency band signal output (7) of the diplexer by forming a resistive connection path.

9. The probe according to the previous claim, wherein the chain of resistor components (13) comprises resistive components having different resistive properties.

10. The probe according to any one of the previous claims, wherein the diplexer comprises a capacitor component (14) arranged between the high frequency band signal output (8) and the input (6) of the diplexer (5).

11. The probe according to any one of the previous claims, wherein the housing is conductive and has at least partially a substantially spherical surface for the purpose of forming a ground plane for the at least one antenna.

12. The probe according to any one of the previous claims, wherein the at least one antenna is a monopole antenna with a resistivity of at least 100 Ohm.

13. The probe according to any one of the previous claims, wherein at least three antennas are arranged on the housing in accordance with three axes oriented perpendicularly of each other;, wherein preferably the at least three antennas comprise six antennas provided in pairs arranged on opposite sides of the housing such that the pairs are arranged on the housing in accordance with three axes oriented perpendicularly of each other.

14. The probe according to any one of the previous claims, wherein each detection circuit comprises at least a peak detector (9, 10), which is connected to the processing unit via a ranging amplifier (15, 16) and an A/D convertor (17, 18).

15. The probe according to any one of the previous claims, wherein the low frequency band extends between a low border and a splitting frequency and the high frequency band extends between the splitting frequency and an upper border, said low border being lower than 25 kHz and said upper border being higher than 2 GHz.

## Patentansprüche

1. Sonde (1) zum Messen eines elektrischen Felds, umfassend:
- mindestens eine Antenne (2), die angepasst ist, um ein Breitband-HF-Signal zu empfangen;
- einen Diplexer (5), umfassend einen Eingang (6), der mit der Antenne gekoppelt ist, wobei der Diplexer konfiguriert ist, um das empfangene Breitband-HF-Signal an einen Niederfrequenzbandsignalausgang (7) und einen Hochfrequenzbandsignalausgang (8) derart zu übertragen, dass das Breitband-HF-Signal in der Kombination des Niederfrequenzbandsignalausgangs (7) und des Hochfrequenzbandsignalausgangs (8) reflektiert wird;
- eine Niederfrequenzbanderfassungsschaltung (9), die mit dem Niederfrequenzbandsignalausgang (7) zum Erfassen eines Niederfrequenzband-HF-Signals verbunden ist und zum Einspeisen des erfassten Signals an eine Verarbeitungsschaltung (4) angepasst ist;
- eine Hochfrequenzbanderfassungsschaltung (10), die mit dem Hochfrequenzbandsignalausgang (8) zum Erfassen eines Hochfrequenzband-HF-Signals verbunden ist und zum Einspeisen des erfassten Signals an die Verarbeitungsschaltung (4) angepasst ist; und
- die Verarbeitungsschaltung (4) zum Verarbeiten der erfassten Signale.

2. Sonde nach Anspruch 1, wobei die Sonde ein Gehäuse (3) umfasst, in dem die Verarbeitungsschaltung (4) angeordnet ist.

3. Sonde nach Anspruch 1 oder 2, wobei die Hochfrequenzbanderfassungsschaltung (10) außerhalb des Gehäuses angeordnet ist.

4. Sonde nach Anspruch 3, wobei die Hochfrequenzbanderfassungsschaltung (10) über einen Durchführungskondensator (12) mit einem Durchführungsanschluss und einem Schild mit der Verarbeitungsschaltung gekoppelt ist, wobei der Durchführungsanschluss die Erfassungsschaltung mit der Verarbeitungsschaltung leitend verbindet und der Schild mit der leitenden Oberfläche des Gehäuses leitend verbunden ist.

5. Sonde nach einem der vorstehenden Ansprüche, wobei die Niederfrequenzbanderfassungsschaltung (9) innerhalb des Gehäuses angeordnet ist.

6. Sonde nach einem der vorstehenden Ansprüche, wobei die Niederfrequenzbanderfassungsschaltung (9) über einen Verstärker (11), vorzugsweise einen FET-Verstärker, stärker bevorzugt einen JFET-Verstärker, mit dem Niederfrequenzbandsignalausgang (7) verbunden ist; wobei vorzugsweise der Verstärker innerhalb des Gehäuses angeordnet ist.

7. Sonde nach einem der vorstehenden Ansprüche, wobei der Diplexer konfiguriert ist, um eine Impedanz an dem Niederfrequenzbandsignalausgang (7) bereitzustellen, die signifikant höher als eine Impedanz an dem Hochfrequenzbandsignalausgang (8) ist.

8. Sonde nach einem der vorstehenden Ansprüche, wobei der Diplexer eine Kette von Widerstandskomponenten (13) umfasst, die einen Abstand zwischen dem Eingang (6) des Diplexers und dem Niederfrequenzbandsignalausgang (7) des Diplexers durch ein Ausbilden eines Widerstandsverbindungswegs überbrückt.

9. Sonde nach dem vorstehenden Anspruch, wobei die Kette von Widerstandskomponenten (13) Widerstandskomponenten umfasst, die unterschiedliche Widerstandseigenschaften aufweisen.

10. Sonde nach einem der vorstehenden Ansprüche, wobei der Diplexer eine Kondensatorkomponente (14) umfasst, die zwischen dem Hochfrequenzbandsignalausgang (8) und dem Eingang (6) des Diplexers (5) angeordnet ist.

11. Sonde nach einem der vorstehenden Ansprüche, wobei das Gehäuse leitend ist und mindestens teilweise eine im Wesentlichen kugelförmige Oberfläche aufweist, für den Zweck des Ausbildens einer Masseebene für die mindestens eine Antenne.

12. Sonde nach einem der vorstehenden Ansprüche, wobei die mindestens eine Antenne eine Monopolantenne mit einem Widerstand von mindestens 100 Ohm ist.

13. Sonde nach einem der vorstehenden Ansprüche, wobei mindestens drei Antennen gemäß drei senkrecht zueinander ausgerichteten Achsen an dem Gehäuse angeordnet sind, wobei vorzugsweise die mindestens drei Antennen sechs Antennen umfassen, die paarweise auf gegenüberliegenden Seiten des Gehäuses derart angeordnet sind, dass die Paare an dem Gehäuse gemäß drei senkrecht zueinander ausgerichteten Achsen angeordnet sind.

14. Sonde nach einem der vorstehenden Ansprüche, wobei jede Erfassungsschaltung mindestens einen Spitzendetektor (9, 10) umfasst, der über einen Bereichsverstärker (15, 16) und einen A/D-Wandler (17, 18) mit der Verarbeitungseinheit verbunden ist.

15. Sonde nach einem der vorstehenden Ansprüche, wobei sich das Niederfrequenzband zwischen einer niedrigen Grenze und einer Teilungsfrequenz erstreckt und sich das Hochfrequenzband zwischen der Teilungsfrequenz und einer oberen Grenze erstreckt, wobei die niedrige Grenze niedriger als 25 kHz ist und die obere Grenze höher als 2 GHz ist.

## Revendications

1. Sonde (1) permettant de mesurer un champ électrique, comprenant :
- au moins une antenne (2) adaptée à la réception d'un signal RF à large bande ;
- un diplexeur (5) comprenant une entrée (6) couplée à l'antenne, le diplexeur étant configuré pour transmettre le signal RF à large bande reçu à une sortie de signal de bande basse fréquence (7) et une sortie de signal de bande haute fréquence (8) de telle sorte que le signal RF à large bande est réfléchi dans la combinaison de la sortie de signal de bande basse fréquence (7) et de la sortie de signal de bande haute fréquence (8) ;
- un circuit de détection de bande basse fréquence (9) connecté à la sortie de signal de bande basse fréquence (7) permettant de détecter un signal RF de bande basse fréquence, et adapté pour l'envoi du signal détecté à un circuit de traitement (4) ;
- un circuit de détection de bande haute fréquence (10) connecté à la sortie de signal de bande haute fréquence (8) permettant de détecter un signal RF de bande haute fréquence et adapté à l'envoi du signal détecté audit circuit de traitement (4) ; et
- ledit circuit de traitement (4) permettant de traiter les signaux détectés.

2. Sonde selon la revendication 1, dans laquelle la sonde comprend un boîtier (3) dans lequel le circuit de traitement (4) est agencé.

3. Sonde selon la revendication 1 ou 2, dans laquelle le circuit de détection de bande haute fréquence (10) est agencé à l'extérieur dudit boîtier.

4. Sonde selon la revendication 3, dans laquelle le circuit de détection de bande haute fréquence (10) est couplé au circuit de traitement par l'intermédiaire d'un condensateur de traversée (12) avec un terminal de traversée et un blindage, dans laquelle le terminal de traversée connecte le circuit de détection de manière conductrice au circuit de traitement et le blindage est connecté de manière conductrice à la surface conductrice du boîtier.

5. Sonde selon l'une quelconque des revendications précédentes, dans laquelle le circuit de détection de bande basse fréquence (9) est agencé à l'intérieur dudit boîtier.

6. Sonde selon l'une quelconque des revendications précédentes, dans laquelle le circuit de détection de bande basse fréquence (9) est connecté à la sortie de signal de bande basse fréquence (7) par l'intermédiaire d'un amplificateur (11), de préférence un amplificateur FET, plus préférentiellement un amplificateur JFET ; dans laquelle de préférence l'amplificateur est agencé à l'intérieur dudit boîtier.

7. Sonde selon l'une quelconque des revendications précédentes, dans laquelle le diplexeur est configuré pour fournir une impédance au niveau de la sortie de signal de bande basse fréquence (7) qui est significativement plus élevée qu'une impédance au niveau de la sortie de signal de bande haute fréquence (8).

8. Sonde selon l'une quelconque des revendications précédentes, dans laquelle le diplexeur comprend une chaîne de composants de résistance (13) pontant une distance entre l'entrée (6) du diplexeur et la sortie de signal de bande basse fréquence (7) du diplexeur en formant un chemin de connexion résistif.

9. Sonde selon la revendication précédente, dans laquelle la chaîne de composants de résistance (13) comprend des composants résistifs ayant des propriétés résistives différentes.

10. Sonde selon l'une quelconque des revendications précédentes, dans laquelle le diplexeur comprend un composant de condensateur (14) agencé entre la sortie de signal de bande haute fréquence (8) et l'entrée (6) du diplexeur (5).

11. Sonde selon l'une quelconque des revendications précédentes, dans laquelle le boîtier est conducteur et a au moins partiellement une surface sensiblement sphérique dans le but de former un plan de masse pour l'au moins une antenne.

12. Sonde selon l'une quelconque des revendications précédentes, dans laquelle l'au moins une antenne est une antenne unipolaire avec une résistivité d'au moins 100 Ohm.

13. Sonde selon l'une quelconque des revendications précédentes, dans laquelle au moins trois antennes sont agencées sur le boîtier conformément à trois axes orientés perpendiculairement les uns des autres ;dans laquelle de préférence les au moins trois antennes comprennent six antennes fournies en paires agencées sur des côtés opposés du boîtier de telle sorte que les paires sont agencées sur le boîtier conformément à trois axes orientés perpendiculairement les uns des autres.

14. Sonde selon l'une quelconque des revendications précédentes, dans laquelle chaque circuit de détection comprend au moins un détecteur de crête (9, 10), qui est connecté à l'unité de traitement par l'intermédiaire d'un amplificateur de télémétrie (15, 16) et d'un convertisseur A/N (17, 18).

15. Sonde selon l'une quelconque des revendications précédentes, dans laquelle la bande basse fréquence s'étend entre une limite basse et une fréquence de division et la bande haute fréquence s'étend entre la fréquence de division et une limite supérieure, ladite limite basse étant inférieure à 25 kHz et ladite limite supérieure étant supérieure à 2 GHz.
